# EUROPEAN PATENT APPLICATION

(11) **EP 3 185 319 A1**
(43) Date of publication of application: **28.06.2017**
(21) Application number: 15307149.3
(22) Date of filing: 24.12.2015
(51) Int. Cl.: H01L 35/32, C08J 3/215, C08K 3/38, H01L 35/34

(54) **COMPOSITE MATERIAL AND THERMOELECTRIC MODULE**

(71) Applicant: ALCATEL LUCENT, 92100 Boulogne-Billancourt (FR)
(72) Inventor: CUNNINGHAM, Graeme, Dublin, 15 (IE)
(74) Representative: Shamsaei Far, Hassan

(57) **Abstract**

A composite material, a method of making the composite material and a thermoelectric module comprising the composite material are disclosed. The composite material comprises a flexible, electrically insulating polymer and an electrically insulating and thermally conductive nanomaterial dispersed within a solid, flexible structure.

## Description

The present disclosure relates to devices having thermoelectric properties.

### BACKGROUND

As it is known, thermoelectric (TE) materials are capable of converting thermal energy into electric energy and vice versa. For example when a temperature difference is present between a point on one side of a TE material and another point on another side of the TE material, a voltage may be generated across the two points. Conversely when an electric potential difference is present between a point on one side of a TE material and another point on another side of the TE material, a temperature difference is generated across the two points.

### SUMMARY

Some embodiments feature a composite material, comprising a flexible, electrically insulating polymer and an electrically insulating and thermally conductive nanomaterial dispersed within a solid, flexible structure.

According to some specific embodiments, a ratio in volume between the nanomaterial and the polymer making up the composite is determined based on the level of thermal conductivity required.

According to some specific embodiments, the polymer is polyimide.

According to some specific embodiments the nanomaterial is BN.

Some embodiments feature a thermoelectric module comprising a thermoelectric material located on or adjacent a substrate wherein the substrate is the composite is the composite as disclosed herein.

According to some specific embodiments, the thermoelectric material is Bi₂Te₃ According to some specific embodiments the thermoelectric material is flexible to thereby render the thermoelectric module flexible.

According to some specific embodiments the thermoelectric module is vertically configured.

Some embodiments feature a method of making a composite material comprising:
- dissolving a polymer in a solvent;
- dissolving a nanomaterial in the same solvent;
- disperse the polymer and the nanomaterial inside the solvent to thereby provide a homogenous mixture; and
- curing the solution to thereby obtain the composite material.

According to some specific embodiments, the ratio between the nanomaterial and the polymer making up the composite is determined based on the level of thermal conductivity required.

According to some specific embodiments, the polymer is polyimide.

According to some specific embodiments the nanomaterial is BN.

According to some specific embodiments the solvent is N-Methyl-2-pyrrolidone. According to some specific embodiments dispersing the polymer and the nanomaterial inside the solvent to make a homogenous mixture is performed by stirring or sonication.

These and further features and advantages of the present disclosure are described in more detail, for the purpose of illustration and not limitation, in the following description as well as in the claims with the aid of the accompanying drawings.

### BRIEF DESCRIPTION OF THE DRAWINGS

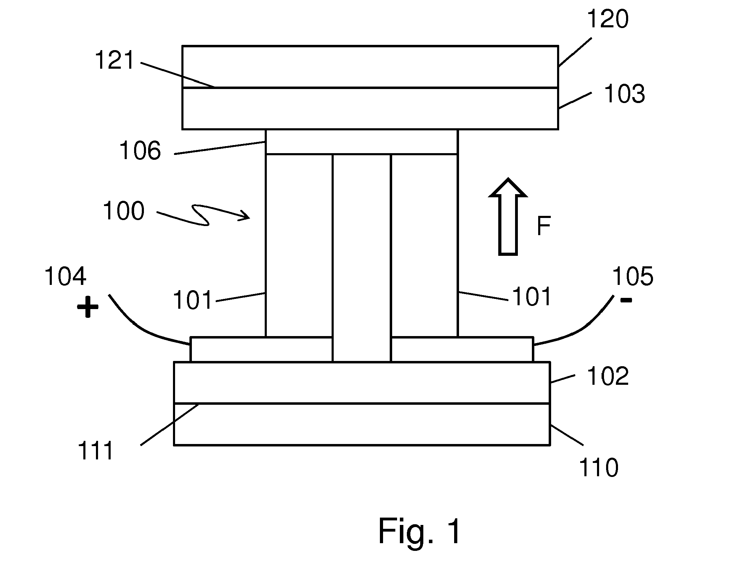

Figure 1 is an exemplary schematic representation of a known vertically configured TE module placed between two elements.

### DETAILED DESCRIPTION

Thermoelectric modules (TEM) are typically structures comprising a thermoelectric material provided on a substrate. As mentioned above, TEMs may typically be used to transfer heat, by applying a voltage (or current) for cooling applications in which the device functions as a solid state heat pump which pumps heat from cold to hot via the charge carriers; or they may be used to generate electricity from a temperature difference present at its two sides. In order to obtain efficient response in either of these two applications, it is desirable that the TEM is capable of making good adherence to the bodies with which the TEM exchanges heat.

Thermoelectric structures typically are made of a plurality of n-type and p-type material having charged particles (electrons and holes respectively) which can diffuse within the structure from a hotter side to a colder side thereby generating an electric potential. Thermoelectric structures may also be made of only of the above-mentioned n-type and p-type materials, however the structures having both type of materials are commercially more popular.

Therefore the specific coupling structure between the n-type material and the p-type material can determine the direction of the electric charge flow or that of the heat transfer. For the sake of simplicity, the direction of the electric charge flow or that of the heat transfer will herein, where appropriate, also be referred to as the direction of flow.

In practice TEMs may be made in the so called "vertical" or "lateral" configurations. These terms are known to a person of ordinary skill in the related art. As a simplified and non-limiting explanation it may be said that assuming that a TEM is placed on a planar surface of a fist body (e.g. a heat source) to absorb heat, the TEM would be considered of vertical configuration if the direction of flow in the TEM is substantially perpendicular to the planar surface of the first body, and it would be considered lateral if the direction of flow is substantially parallel to the planar surface. Vertical configurations are also referred to out-of-plane and lateral configurations are also referred to as in-plane configurations.

The above explanation of the terms "lateral" and "vertical" is to be understood only in the context of defining possible structures of TEMs with respect to general directions of flow, known in the art, and not in an absolute language sense. TEMs may be made of a variety of materials. Bismuth Telluride (Bi2Te3) and its alloys with Antimony Telluride are some examples of suitable materials. Further examples are antimony telluride (Sb2Te3) and bismuth selenide (Bi2Se3), which are alloyed into Bi2Te3 to make the p and n type TE materials respectively. They are structurally and electronically similar materials. For example, the n type material may be a solid solution alloy of Bi2Te3/Bi2Se3 and the p type material may be a solid solution alloy of Bi2Te3/Sb2Te3.

However, for the intended purpose as disclosed herein, any TE materials that do not operate at temperatures above 700 degrees C may also be used as this is the temperature at which the Kapton/polyimide typically begins to degrade. Furthermore, TEMs typically comprise one or more substrates which support the TE material. One known substrate for TEMs is polyimide which has certain properties that earmark it as a superior substrate material for Bi2Te3 based TEMs. For example polyimide has high chemical and temperature stability, flexibility and strong adherence to Bi2Te3, whilst matching its thermal co-efficient of expansion relatively closely. These attributes have made polyimide a popular choice for the laterally configured TEMs which typically are easier to produce, although typically less efficient, as compared to the vertically configured TEMs.

In the case of laterally configured TEMs, it is typically desired that the substrate has negligible or very low thermal conductivity as such thermal conductivity may create a thermal shunt in a direction which is not the desired (lateral) direction of flow and therefore may reduce the device efficiency.

Polyimide indeed has an ultra-low thermal conductivity (0.1 W/m K). However, this property is undesirable for vertically configured TEMs, as in this case a high thermal resistance decreases the thermal conductance in the desired (vertical) direction of flow.

As a consequence, despite its inherent suitability for the particular application of Bi2Te3 based TEMs, polyimide typically has not been used in the known techniques for making vertically configured TEMs.

For the sake of clarity with respect to the use of the term thermal conductivity, or said in other words, heat transfer, as used herein, the following clarification is provided. As it is known, many materials, and even from a pure theoretical standpoint any material, may be considered to be thermally conductive (thus having heat transfer capabilities) as each material has a certain level of thermal conductivity, even if in some cases such level is very low. However, within the context of the present disclosure, a person of ordinary skill in the related art would be able to distinguish a material which is considered in the art as thermally conductive from one which is not so considered, such as for example a thermal insulator.

By way of still further clarification, it is noted that within the context of the present disclosure, any material having a thermal conductivity greater than about 1W/mK (Watts per Meter Kelvin) may be considered as a thermally conductive material. Conversely, any material having a thermal conductivity of less than about 1W/mK may be considered as thermally non-conductive. Accordingly, polyimide having a thermal conductivity of about 0.1 W/m K is, in the context of the present disclosure, considered thermally non-conductive.

In the addition to the above requirement of having good thermal conductivity, it is also important that a thermoelectric substrate is electrically insulating so as to prevent electric shorting between elements with which it is in physical contact.

Some known materials which simultaneously fulfill the requirements of being thermally conductive and electrically insulating are highly crystalline dielectrics such as diamond or alumina. However, these materials are relatively costly to manufacture and source. Furthermore, these materials are typically not flexible. Therefore using such crystalline substrates renders the whole device rigid, making them unsuitable for applications in which flexibility of the thermoelectric module is desired such as in wearable technology.

Figure 1 illustrates a simplified example of a vertically configured thermoelectric module (TEM) 100, according to embodiments of the disclosure. The structure in figure 1 only shows one p-n thermocouple pair 101 coupled with each other by means of a metal contact layer 106, however those of ordinary skill in the related art will understand that a typical TEM is comprised of many, e.g. hundreds or thousands, of such pairs connected electrically in series and thermally in parallel. In this figure, the TEM 100 is placed between two elements 110 and 120 which may be any two bodies having a temperature difference (gradient) between each other.

In some embodiments, one element 110 may be a heat source such as an electronic component which is heated during operation and the other element 120 may be a heat dissipater such as a heat sink as known in the related art. An electric voltage applied across the TEM 100 through electrodes 104 and 15 may cause the TEM to transfer heat from the heat source 110 to the heat sink 120 thereby operating as a cooling mechanism.

In other embodiments, the temperature gradient between elements 110 and 120 may be converted into electric potential which is provided at terminals represented by electrodes 104 and 105. For example one element 110 maybe a part of an automobile which is heated during operation and the other element 120 may be a heat dissipater capable of transferring heat to the ambient.

TEM 100 comprises a section of thermoelectric (TE) material 101, a first substrate 102 and a second substrate 103. Although TEMs may be made using only one substrate (especially the laterally configured structures), however, for vertically configured TEMs two substrates are preferred. Also while the TE material is shown to be sandwiched between the two substrates, the disclosure is not so limited and other structural configurations may likewise be used with the TE material being located adjacent the one or more substrates (contacting the substrates directly or indirectly through metal contacts). The TE material of section 101 may be for example Bi₂Te₃.

As the TEM 100 of figure 1 is vertically configured, the direction of flow (of heat or electric charges, as the case may be) in this device is vertical as exemplarily shown by arrow F. In the vertically configured TEM 100 of figure 1, it is desired that the substrates 102 and 103 are thermally conductive, so as to enable efficient heat exchange between elements 110 and 120, through the TEM 100 in a direction parallel to arrow F.

As shown in the figure, TEM 100 is placed between respective upper and lower surfaces 111, 121, of elements 110 and 120. In figure 1, TEM 110 and elements 110 and 120 are shown to have a generally planar shape, however this is only exemplary and other shapes for the TEM and the respective elements 110, 120 may be envisaged according to the specific requirements of each application. In all such applications it is desired that the TEM 100 makes, as much as possible, a good thermal contact with the surfaces 111 and 121 of elements 110 and 120 respectively to ensure efficient performance. However in real devices a perfect thermal contact may not be achieved as surfaces often have roughness and unevenness. In such circumstances, therefore, substrates 102 and 103 may not be able to make an efficient thermal contact with the TEM 100.

In some applications, the surfaces 111 and 121 may have curves (not explicitly shown in the figure); therefore the TEM itself and the substrates would need to be flexible to be able to cover such curvy surfaces to ensure an efficient performance.

Bi₂Te₃, being a layered material, posses a certain degree of flexibility making it suitable for making thermal contact with curved, or uneven surfaces. In addition, Bi₂Te₃ has excellent adherence to polyimide, which is also flexible, and matches with the latter in their coefficient of thermal expansion. This means that TEMs utilizing this combination of substrate and active material may be flexible and capable of being twisted, bent, curved or otherwise manipulated to obtain a variety of novel geometries thus allowing much improved thermal contact to the heat source or the heat receiver without such elements blistering or lifting off. For example, one can envisage conformally coated TEMs deployed around irregularly shaped objects such as heat pipes, as well as incorporation into wearable energy harvesting technologies. However, in order to obtain satisfactory results, it is still needed to make polyimide thermally conductive, as will be described further below.

Polymers like polyimide are soluble in organic solvents. On the other hand, nanomaterials having good thermal conductivity, such as graphene or boron nitride (BN) are also solution processable in many of the same organic solvents having similarly relatively low surface energies which is advantageous in order to enable satisfactory dispersing capabilities in the solution. Thus, such nanomaterials may be synergistically incorporated into polymer matrices as a composite, endowed with relative proportions of useful properties from both constituents, giving broader functionality. Nanomaterials are known in the related are. Without limitation, nanomaterials may be described as materials having at least one dimension less than a micrometer.

From the known nanomaterials, graphene has been a popular choice for incorporation as a filler material into polymer matrices. However, the use of graphene for the particular application as intended herein appears to be unsuitable because of its high electrical conductivity.

Nevertheless, a possible solution may be achieved by employing BN which is a structurally similar, although electrically insulating, analogue of graphene with an equally large (lattice) thermal conductivity. This makes BN an ideal candidate as a choice of filler material for making flexible, electrically insulating but thermally conducting polymer-composite substrates for Bi2Te3 based TEMs. There are two forms of BN currently known, these being crystalline and hexagonal (cBN and hBN respectively). From these two known forms, hBN is preferred for the purpose of the present disclosure.

The present disclosure proposes the use of BN to be incorporated into a flexible, electrically insulating polymer such as polyimide to thereby obtain a composite material which is flexible, electrically insulating and thermally conductive thus being suitable for use as a substrate for a Bi2Te3 based TEM, in particular a vertically configured TEM. The following is a non-limiting description of a method of making such composite material.

The composite substrate may be made all in the liquid phase by solution processing methods.

Polyimide is commercially available and typically it may be obtained as a powder. This powder can be made into a solution by mixing with an appropriately chosen solvent. One example, of a suitable solvent is NMP (N-Methyl-2-pyrrolidone). Boron Nitride (BN) is built up from layers of hexagonal rings of alternating B and N atoms stacked on top of each other to form nanosheets (to thereby form a nanomaterial). BN is also commercially available as a powder.

It is known that NMP is a suitable solvent for making dispersions (rather than solutions) from a range of nanomaterials with layered structures. These include but are not limited to graphene, carbon nanotubes and MoS₂ as well as BN. This is due to the well matched (low) surface energies of these materials and NMP. Given that both constituents of the proposed BN-polyimide substrate are readily dispersible in NMP, they may be added to NMP in the desired ratio.

This ratio may be determined according to the particular application; i.e. more BN can be added if a higher thermal conductivity is required but only at the expense of losing some of the flexibility endowed by the polyimide.

Preferably, smaller sized BN nanosheets may be used which are easier to disperse homogenously throughout the liquid and as a result one would require less of the material in this case to achieve the same effect. These can be produced and size selected accordingly prior to beginning processing of the polymer-composite system and depending on the specific application the TEM is being designed for. In the context of the present disclosure BN nanosheets having dimensions of around 100 nm or less are considered to be of small size. Once both materials have been added to the NMP medium they are dispersed to make a homogenous mixture by stirring or sonication with optional application of heat if required.

The resulting composite polymer-nanosheet-solvent dispersion is highly stable and processable into the final substrate by any number of roll to roll print manufacturing techniques commonly employed in printed electronics today. Once the composite is prepared, the solvent may be removed by filtering off or evaporation thereby obtaining the final substrate structure. This structure is then used for fabricating the TEM, for example, by depositing the thermoelectric material thereupon or by other processes such as screen printing, dip coating, spin coating, ink jet printing, etc.

As can be appreciated from the above description, the fabrication process is very simple and also easily scalable to larger volumes.

The proposed solution therefore provides a very low cost and easy to implement process for producing large area electrically insulating but thermally conducting thermoelectric substrate materials for Bi₂Te₃ based thermoelectric modules that are flexible.

From a processing point of view, BN has another advantageous feature over the more commonly used composite filler graphene. Many polymer film formation processes require a light based curing step to activate the cross-linking of the polymer chains which gives it its structural integrity. However, being highly absorbent across the whole UV-visible-IR spectrum means that graphene will interfere undesirably with any necessary curing processes. In contrast, as a wide gap insulator, BN absorbs no or negligible amount of energy in this spectral range which is the range generally required for polymer curing processes, meaning that the curing may be carried out without interference.

It is to be noted that the list of structures corresponding to the claimed means is not exhaustive and that one skilled in the art understands that equivalent structures can be substituted for the recited structure without departing from the scope of the disclosure.

It is also to be noted that the order of the steps of the method of the disclosure as described and recited in the corresponding claims is not limited to the order as presented and described and may vary without departing from the scope of the disclosure.

It should be appreciated by those skilled in the art that any block diagrams herein represent conceptual views of illustrative circuitry embodying the principles of the disclosure.

## Claims

1. A composite material, comprising a flexible, electrically insulating polymer and an electrically insulating and thermally conductive nanomaterial dispersed within a solid, flexible structure.

2. The composite material of claim 1, wherein a ratio in volume between the nanomaterial and the polymer making up the composite is determined based on the level of thermal conductivity required.

3. The composite material of claim 1 or claim 2, wherein the polymer is polyimide.

4. The composite material of any preceding claim, wherein the nanomaterial is BN.

5. A thermoelectric module comprising a thermoelectric material located on or adjacent to a substrate wherein the substrate is the composite material of any one of claims 1 to 4.

6. The thermoelectric module of claim 5, wherein the thermoelectric material is Bi₂Te₃.

7. The thermoelectric module of claim 5 or claim 6, wherein the thermoelectric material is flexible to thereby render the thermoelectric module flexible.

8. The thermoelectric module of any preceding claims 5 to 7, wherein the thermoelectric module is vertically configured.

9. A method of making a composite material comprising:
- dissolving a polymer in a solvent;
- dissolving a nanomaterial in the same solvent;
- disperse the polymer and the nanomaterial inside the solvent to thereby provide a homogenous mixture; and
- curing the solution to thereby obtain the composite material.

10. The method of claim 9, wherein a ratio in volume between the nanomaterial and the polymer making up the composite is determined based on the level of thermal conductivity required.

11. The method of claim 9 or claim 10, wherein the polymer is polyimide.

12. The method of any preceding claim 9 to 11, wherein the nanomaterial is BN.

13. The method of any preceding claim 9 to 12, wherein the solvent is N-Methyl-2-pyrrolidone.

14. The method of any preceding claim 9 to 14, wherein dispersing the polymer and the nanomaterial inside the solvent to make a homogenous mixture is performed by stirring or sonication.
